# EUROPEAN PATENT APPLICATION

(11) **EP 3 147 332 A1**
(43) Date of publication of application: **29.03.2017**
(21) Application number: 15796248.1
(22) Date of filing: 12.05.2015
(51) Int. Cl.: C09B 67/02, B01J 37/02, H01G 9/20, H01L 51/44, C09B 23/00, C09B 57/10

(54) **LOADING METHOD, LOADED BODY AND PHOTOELECTRIC CONVERSION ELEMENT**

(30) Priority: 20.05.2014 JP 2014104632
(71) Applicant: Adeka Corporation, Tokyo 116-8554 (JP)
(72) Inventor: AOYAMA, Yohei, Tokyo 116-8554 (JP); AKIMOTO, Kensaku, Tokyo 116-8554 (JP); TANIUCHI, Ryo, Tokyo 116-8554 (JP); KAKIAGE, Kenji, Tokyo 116-8554 (JP)
(74) Representative: Forstmeyer, Dietmar
(86) International application number: PCT/JP2015/063677
(87) International publication number: WO 2015/178257

(57) **Abstract**

A method for loading a support with a compound in an organic solvent, characterized in that the organic solvent contains an amine. The organic solvent preferably has a hydroxy group. The compound preferably has at least one of carboxyl, sulfonic, phosphoric, phosphonic, and alkoxysilyl groups. The support is preferably a metal oxide, such as titanium oxide, zinc oxide, or aluminum oxide. The resulting compound-loaded support is suited for use as an electrode.

## Description

### Technical Field

The present invention relates a method for loading a compound on a support, a compound-loaded support system obtained by the method, and a photoelectric device.

### Background Art

A variety of technical fields have involved loading a compound on a support. The field of catalyst is one such example. While a catalyst with a smaller particle size is believed to have higher performance because of its increased specific surface area, a finely divided catalyst is difficult to handle and is usually used as fixed on a support. Solid-phase peptide synthesis is another example, in which amino acids are successively caused to react on a polymer having a specific modifying group to obtain a peptide having a designed amino acid sequence in high yield. That is, the loading technique for fixing a compound onto a support is used to provide a site where a specific function is performed or a reaction is controlled.

Devices that generate an electrical power output in response to light (input) have been studied extensively. Such photoelectric devices include light sensors, such as a light detector, and photovoltaic devices, such as a solar cell. In particular, a photovoltaic device such as a solar cell, which converts inexhaustible sunlight to electrical energy, has been under intensive study in expectation of a solution to the energy-resource issue and in view of low environmental burden. There are many types of photovoltaic devices. Among them, a dye-sensitized solar cell uses an electrode including a metal oxide semiconductor (support) loaded with a dye compound.

Loading a compound on a support is generally carried out in a liquid phase. A compound is loaded on a support through chemical or physical adsorption. In loading (fixing) a compound on a support, the amount of the compound that can be supported on a support and the stability of compound fixation are of importance. The details of the adsorption characteristics in a dye-sensitized solar cell are described in Patent Literatures 1 and 2 below.

### Citation List

### Patent Literature:

Patent Literature 1: JP 2012-084250A
Patent Literature 2: JP 2013-194105A

### Summary of Invention

### Technical Problem

An object of the invention is to provide a method for loading a support with an increased amount of a compound. Another object is to provide a compound-loaded support system obtained by the method and a photoelectric device using the support system as an electrode.

### Solution to Problem

As a result of extensive investigations, the inventors have found that the above objects are accomplished by the use of an organic solvent containing an amine and reached the present invention.

The present invention provides a method for loading a compound on a support in an organic solvent, wherein the organic solvent contains an amine.

The present invention provides the method described above, wherein the organic solvent has a hydroxy group.

The present invention provides the method described above, wherein the compound has at least one group selected from a carboxyl group, a sulfonic group, a phosphate group, a phosphonic group, and an alkoxysilyl group.

The present invention provides the method described above, wherein the support is a metal oxide.

The present invention provides a compound-loaded support system obtained by the method described above.

The present invention provides a photoelectric device including an electrode containing the compound-loaded support system described above.

### Advantageous Effects of Invention

The loading method of the invention allows for fixing an increased amount of a compound onto a support thereby to achieve high support system productivity. The support system of the invention, having a high compound-to-support ratio, provides a photoelectric device having excellent characteristics when used as an electrode.

### Brief Description of Drawings

[Fig. 1] Fig. 1 schematically illustrates a cross-sectional structure of a photoelectric device according to the invention.
[Fig. 2] Fig. 2 is an enlarged view of an essential part of the photoelectric device of the invention shown in Fig. 1.

### Description of Embodiments

The loading method of the invention, the compound-loaded support system obtained by the loading method, and the photoelectric device will be described on the basis of their preferred embodiment.

The loading method of the invention is first described.

The loading method of the invention includes bringing a compound to be loaded into contact with a support by immersing the support in an organic solvent containing an amine and the compound to be loaded. While it is preferred that the compound to be loaded be dissolved in the organic solvent, it is no problem if the compound is in a dispersed state in the organic solvent as long as it will be loaded on the support.

The temperature of the organic solvent containing the amine and the compound to be loaded, in which the support is to be immersed, is preferably 0° to 80°C, more preferably 20° to 50°C. The time of immersing the support in the organic solvent containing the amine and the compound to be loaded is preferably 30 minutes to 24 hours, more preferably 1 to 5 hours.

After the immersion, the support loaded with the compound is taken out of the organic solvent and may be subjected to a step of removing the organic solvent and the amine (removing step). When the organic solvent and the amine remaining in the support system pose no problem in the use of the support system, the removing step is unnecessary. The removing step is carried out using an amine-free organic solvent, usually an organic solvent having a lower boiling point than the organic solvent used in the loading step.

When it is undesirable depending on the use of the support system that the organic solvent and amine used in the loading step and the organic solvent used in the removing step remain in the support system, the support system may be subjected to a drying step. The drying step is usually conducted by drying under heating, drying under reduced pressure, or a combination thereof.

As used herein, the term "load" as a verb and its cognates mean to provide a state in which a compound and a support are connected to each other by chemical, physical, or electrical bonding or adsorption.

The amine concentration in the organic solvent is usually in the range of from 0.01 to 1 mol%. Too low an amine concentration can produce only a small effect on the improvement of loading ratio. Too high an amine concentration can make a washing step (hereinafter described) difficult to carry out or worsen the working environment.

The amount of the amine to be used is usually 0.1 to 1000 mol, preferably 1 to 100 mol, per 1 mole of the compound to be loaded.

Materials used in the method of the invention are then described in sequence.

### I. Organic solvent

Any organic solvent is usable as long as it is capable of dissolving the compound to be loaded. Examples of suitable organic solvents include hydrocarbons, such as toluene, benzene, and xylene; alcohols, such as methanol, ethanol, isopropyl alcohol, n-butanol, and t-butanol; ether alcohols, such as methyl cellosolve, ethyl cellosolve, butyl cellosolve, and butyl diglycol; ketones, such as acetone, methyl ethyl ketone, methyl isobutyl ketone, cyclohexanone, and diacetone alcohol; esters, such as ethyl acetate, butyl acetate, and methoxyethyl acetate; acrylic esters, such as ethyl acrylate and butyl acrylate; halogenated alcohols, such as 2,2,3,3-tetrafluoropropanol; chlorinated hydrocarbons, such as methylene dichloride, dichloroethane, and chloroform; acetonitrile, and tetrahydrofuran. These organic solvents may be used as a mixture in any mixing ratio. Preferred of them are alcohols, ketones, esters, halogenated alcohols, acetonitrile, and tetrahydrofuran in view of high loading ratio. More preferred are alcohols and halogenated alcohols having a hydroxy group. Even more preferred are alcohols. In other words, the organic solvent preferably has a hydroxy group.

The organic solvents may be used either individually or in combination of two or more thereof. In the case that the organic solvents are used in combination, at least one of the organic solvents to be combined is preferably an organic solvent having a hydroxy group.

### II. Amine

The method of the invention is characterized by using an organic solvent containing an amine. The amine to be used does not need to be liquid. However, if the amine is solid, it should be dissolved in the organic solvent. The amine is preferably a compound that is removable together with the organic solvent in a washing step after loading the compound on the support.

Specific examples of the amine include tertiary amines, such as triethylamine, tripropyleneamine, tributylamine, trihexylamine, triheptylamine, trioctylamine, trinonylamine, tridecylamine, diisopropylethylamine, N,N'-dimethylpiperazine, diethylaniline, benzyldimethylamine, tribenzylamine, tris(2-ethylehxyl)amine, N,N-dimethyldecylamine, N-benzyldimethylamine, butyldimethylamine, N,N-dimethylcyclohexylamine, N,N,N',N'-tetramethylethylenediamine, N,N-dimethylaniline, N,N-diethylaniline, 1,4-diazabicyclo[2.2.2]octane, N-methylpyrrolidine, N-methylpiperidine, N-methylmorpholine, N-ethylmorpholine, N,N'-dimethylpiperazine, N-methylpipecoline, N-methylpyrrolidone, N-vinylpyrrolidone, bis(2-dimethylaminoethyl) ether, N,N,N,N',N"-pentamethyldiethylenetriamine, methylpiperidine, butyldiethanolamine, triethanolamine, tripropanolamine, dimethylethanolamine, dimethylaminoethoxyethanol, N,N-dimethylaminopropylamine, N,N,N',N',N"-pentamethyldipropylenetriamine, tris(3-dimethylamnopropyl)amine, tetramethylimino-bis(propylamine), and N-diethylethanolamine; secondary amines, such as diethylamine, dibutylamine, dipentylamine, dihexylamine, piperidine, piperazine, and diphenylamine; primary amines, such as propylamine, butylamine, pentylamine, hexylamine, octylamine, ethanolamine, and aniline; and aromatic amines, such as pyridine, 4-dimethylaminopyridine, imidazole, and methylimidazole. Preferred of them are primary, secondary, and tertiary amines, including triethylamine, tripropyleneamine, tributylamine, trihexylamine, triheptylamine, trioctylamine, trinonylamine, tridecylamine, diisopropylethylamine, butyldimethylamine, diethylamine, dibutylamine, dipentylamine, dihexylamine, propylamine, butylamine, pentylamine, hexylamine, and octylamine.

### III. Support

Examples of the support material include organic resins, such as acrylic resins and fluororesins, metal oxides, such as titanium oxide, zinc oxide, and aluminum oxide, silicon oxide, zeolite, and activated carbon. Supports having a porous surface, particularly metal oxides are preferred. The shape of the support is not particularly limited and may be chosen as appropriate to the use of the support system from, for example, film, powder, granule, and so on. The size of the support and the amount of the compound to be loaded are not particularly limited and may be selected as appropriate to the use of the support system.

### IV. Compound to be loaded

The compound to be loaded on the support is not particularly limited as long as it is fixable onto the support. The compound preferably has at least one group selected from a carboxyl group, a sulfonic group, a phosphate group, a phosphonic group, and an alkoxysilyl group; for such a compound exhibits high fixing stability on the support and is readily susceptible to the effect of the amine used in the invention in increasing the loaded amount. The carboxyl group, sulfonic group, phosphate group, and phosphonic group may be in the form of salt. A compound having a carboxyl group is particularly preferred for enjoying higher effects of the amine.

When the compound loaded on the support by the loading method of the invention is a dye compound capable of being excited by sunlight or room light and injecting electrons into the support or moving the charges to another loaded compound, the support system obtained by the loading method of the invention is applicable to a dye-sensitized solar cell. Examples of such a dye compound include organic dyes, such as eosin Y, dibromofluoroscein, fluorescein, rhodamine B, pyrrogallol, dichlorofluorescein, Erythrosine B (registered trade name), fluorescin, merbromin, merocyanine disazo dyes, trisazo dyes, anthraquinone dyes, polycyclic quinone dyes, indigo dyes, diphenylmethane dyes, trimethylmethane dyes, quinoline dyes, benzophenone dyes, naphthoquinone dyes, perylene dyes, fluorenone dyes, squarylium days, azulenium dyes, perinone dyes, quinacridone dyes, metal-free phthalocyanine dyes, metal-free porphyrine dyes, and metal-free azaporphyrin dyes.

Organic metal complex compounds may also be used as a dye compound. Examples of the organic metal complex compounds include those having both an ionic coordinate bond formed between a nitrogen anion of an aromatic heterocyclic ring and a metal cation and a nonionic coordinate bond formed between a nitrogen atom or a chalcogen atom and a metal cation and those having both an ionic coordinate bond formed between an oxygen or sulfur anion and a metal cation and a nonionic coordinate bond formed between a nitrogen or chalcogen atom and a metal cation. Specific examples of the organic metal complex compounds include metallophthalocyanine dyes, such as copper phthalocyanine, titanyl phthalocyanine, cobalt phthalocyanine, nickel phthalocyanine, and iron phthalocyanine; metallonaphthalocyanine dyes, metalloporphyrin dyes, metalloazaporphyrin dyes; bipyridyl, terpyridyl, phenanthroline, bicinchoninate, azo, or quinolinol metal complexes using ruthenium, iron, or osmium; and other ruthenium complexes.

The support system of the invention is also useful in catalyst preparation and solid-phase peptide synthesis. In the case where the loaded compound is a dye compound, the compound-loaded support system is useful in not only photoelectric devices described below but coloring materials, such as toner.

The compound-loaded support system of the invention used as an electrode of a photoelectric device, especially a dye-sensitized solar cell device, will be described with reference to its structure and so forth.

The method for making the support system for use as an electrode of a dye-sensitized solar cell will be described, followed by the structure of the dye-sensitized solar cell.

The support system of the invention is made as follows. An electroconductive substrate 11 having an electroconductive layer 11B is provided. A metal oxide semiconductor layer 12 having a porous structure (support) is formed on the electroconductive layer (11B) side of the substrate 11 by electrodeposition or a firing method. Electrodeposition to form the metal oxide semiconductor layer 12 is carried out by, for example, immersing the electroconductive substrate 11 in an electrolytic bath containing a metal salt providing a metal oxide semiconductor material at a predetermined bath temperature while bubbling with oxygen or air and applying a given voltage between the substrate 11 and a counter electrode to deposit a metal oxide semiconductor material with a porous structure on the electroconductive layer 11B. The counter electrode may be moved appropriately in the electrolytic bath. The firing method is carried out by, for example, dispersing powder of a metal oxide semiconductor material in a medium, applying the resulting metal oxide slurry to the electroconductive substrate 11, followed by drying, followed by firing to form a porous structure. Then a dye solution containing an organic solvent, an amine, and a dye 13 (a compound to be supported) is prepared. The electroconductive substrate 11 having the metal oxide semiconductor layer 12 is immersed in the dye solution to load the dye 13 on the metal oxide semiconductor layer 12.

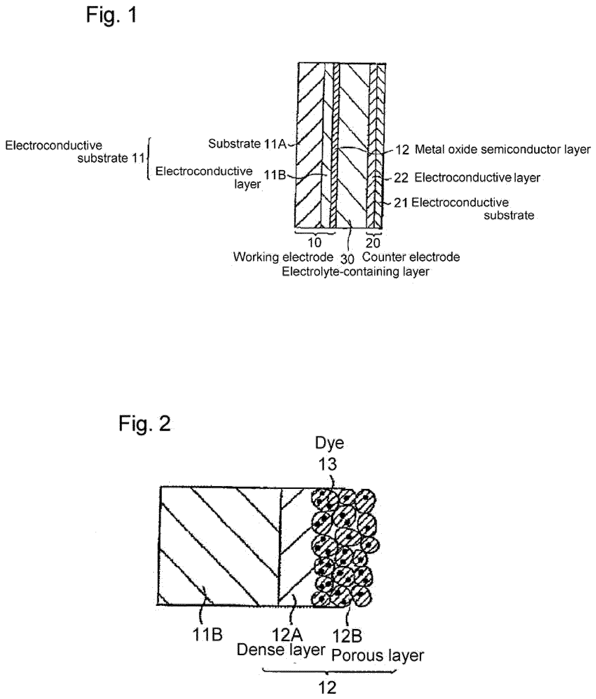

Fig. 1 schematically shows a cross-sectional structure of a photoelectric device according to the invention, and Fig. 2 is an enlarged view of an essential part of the photoelectric device of the invention shown in Fig. 1. The photoelectric device of Figs. 1 and 2 is a principal part of a dye-sensitized solar cell. The photoelectric device includes a working electrode 10 and a counter electrode 20 facing each other with an electrolyte-containing layer 30 therebetween. At least one of the working electrode 10 and the counter electrode 20 is light-transmissive.

The working electrode 10 has, for example, an electroconductive substrate 11, a metal oxide semiconductor layer 12 provided on one side of the substrate 11 (on the side facing the counter electrode 20), and a dye 13 loaded on the metal oxide semiconductor layer 12.

The working electrode 10 functions as a negative electrode of an outer circuit. The electroconductive substrate 11 is, for example, composed of an insulating substrate 11A and an electroconductive layer 11B provided on the surface of the insulating substrate 11A.

Suitable materials of the substrate 11A include insulating materials, such as glass and plastics. Plastics are used in the form of transparent polymer film. The plastics formed of transparent polymer film include tetraacetyl cellulose (TAC), polyethylene terephthalate (PET), polyethylene naphthalate (PEN), syndiotactic polystyrene (SPS), polyphenylene sulfide (PPS), polycarbonate (PC), polyarylate (PAR), polysulfone (PSF), polyester sulfone (PES), polyetherimide (PEI), cyclic polyolefins, and brominated phenoxy resins.

The electroconductive layer 11B is exemplified by a thin film of an electroconductive metal oxide, such as indium oxide, tin oxide, indium-tin complex oxide (ITO), or fluorine-doped tin oxide (FTO or F-SnO₂), a thin film or mesh of a metal, such as gold (Au), silver (Ag), or platinum (Pt), or an electroconductive polymer film.

The electroconductive substrate 11 may be a monolithic structure made of an electroconductive material. In that case, examples of the material of the electroconductive substrate 11 include electroconductive metal oxides, such as indium oxide, tin oxide, indium-tin complex oxide, or fluorine-doped tin oxide, metals, such as gold, silver, or platinum, and electroconductive polymers.

The metal oxide semiconductor layer 12 is a support loaded with the dye 13. The metal oxide semiconductor layer 12 has, for example, a porous structure as illustrated in Fig. 2. The metal oxide semiconductor layer 12 is formed of a dense sublayer 12A and a porous sublayer 12B. The dense sublayer 12A is formed on the interface between the electroconductive substrate 11 and the metal oxide semiconductor layer 12 and is preferably dense and void-free, more preferably filmy. The porous sublayer 12B is formed on the surface in contact with the electrolyte-containing layer 30. The porous sublayer 12B preferably has a structure with many voids and a large surface area, more preferably a structure composed of porous particles adhering to one another. The metal oxide semiconductor layer 12 may have a single layer structure of film form.

Examples of the material contained in the metal oxide semiconductor layer 12 (metal oxide semiconductor material) include titanium oxide, zinc oxide, tin oxide, niobium oxide, indium oxide, zirconium oxide, tantalum oxide, vanadium oxide, yttrium oxide, aluminum oxide, and magnesium oxide. Preferred of them are titanium oxide and zinc oxide; for they provide high conversion efficiency. These metal oxide semiconductor materials may be used either individually or in combination of two or more thereof in the form, e.g., of mixture, mixed crystal, solid solution, or one on surface of another. For example, titanium oxide and zinc oxide may be used in combination.

The metal oxide semiconductor layer 12 having a porous structure can be formed by, for example, electrodeposition, coating, or firing. Electrodeposition to form the metal oxide semiconductor layer 12 is carried out by immersing the electroconductive substrate 11 in an electrolytic bath containing a particulate metal oxide semiconductor material to cause the particles to adhere to and precipitate on the electroconductive layer 11B of the electroconductive substrate 11. In the case of the coating method, a dispersion of a particulate metal oxide semiconductor material (metal oxide slurry) is applied to the electroconductive substrate 11 and then dried to remove the dispersion medium. In the case of the firing method, the metal oxide slurry is applied to the electroconductive substrate 11 and dried in the same manner as in the coating method, followed by firing. The electrodeposition or coating method is advantageous in that a less heat-resistant plastic material or polymer film material is allowed to be used to form the substrate 11A thereby making it possible to provide a highly flexible electrode.

The metal oxide semiconductor layer 12 may be treated with an organic base, a urea derivative, or a cyclic saccharide chain. Examples of the organic base include diarylamines, triarylamines, pyridine, 4-t-butylpyridine, polyvinylpyridine, quinoline, piperidine, and amidines. The treatment may be effected either before or after the hereinafter described adsorption of the dye 13. The treatment may be carried out by immersion. In using a solid treating agent, the treating agent is dissolved in an organic solvent to prepare a solution, in which the metal oxide semiconductor layer 12 is immersed.

The dye 13 is in a state loaded on the metal oxide semiconductor layer 12. The dye 13 includes at least one dye (sensitizing dye) capable of being excited on absorbing incident light and injecting electrons to the metal oxide semiconductor layer 12. Since the dye 13 is loaded by the loading method of the invention in which the organic solvent contains an amine, a dye compound having an anchor group, such as a carboxyl group, is loaded in an increased amount at a high loading ratio. A dye compound having no anchor group may be used in combination with the dye compound having an anchor group.

The dye 13 may contain, in addition to the above described dye, one or more additives. The additives include dye association inhibitors that inhibit dye association. The dye association inhibitors are exemplified by cholic acid compounds represented by chemical formula (1) below. These compounds may be used either individually or as a mixture of two or more thereof. 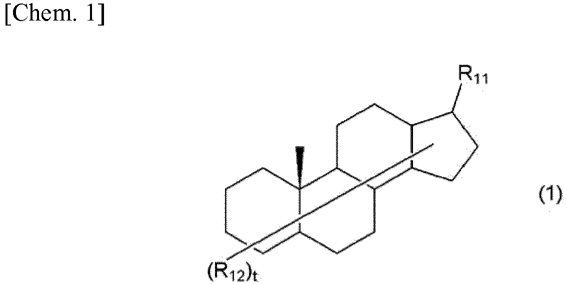 (wherein R₁₁ represents an alkyl group having an acidic group or an alkoxysilyl group; R₁₂ represents a group bonded to any of carbon atoms constructing the steroid structure and selected from a hydroxy group, a halogen atom, an alkyl group, an alkoxy group, an aryl group, a heterocyclic group, an acyl group, an acyloxy group, an oxycarbonyl group, an oxo group, an acidic group, an alkoxysilyl group, and derivatives of these groups; a plurality of R₁₂ groups may be the same or different; t represents an integer of 1 to 5; and the carbon-to-carbon bonds constructing the steroid structure may be either a single bond or a double bond.)

As another example of useful additives, a coadsorbent can be used with a view to improving photoelectric efficiency. A coadsorbent is exemplified by a compound represented by general formula (2): 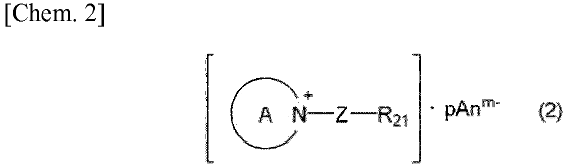
(wherein ring A represents a 5- or 6-membered heterocyclic ring optionally fused to one or more rings and optionally substituted with a halogen atom, a cyano group, a nitro group, -OR²-, -SR²-, or a substituted or unsubstituted hydrocarbon group;
Z represents a divalent aliphatic hydrocarbon group optionally interrupted by
-O-, -S-, -CO-, -COO-, -OCO-, -CONR³-, -NR³CO-, or -Z¹- at 1 to 3 positions; Z¹ represents a divalent aromatic group;
R₂₁ represents a group selected from a carboxylic group, sulfonic group, phosphate group, and phosphonic group;
R² and R³ each independently represent a hydrogen atom or a substituted or unsubstituted hydrocarbon group;
An^{m-} represents an m-valent anion; m represents an integer 1 or 2; and p represents a coefficient for maintaining overall charge neutrality.)

The counter electrode 20 is composed, e.g., of an electroconductive substrate 21 and an electroconductive layer 22 provided thereon and functions as a positive electrode of an outer circuit. Materials for making the electroconductive substrate 21 include those described for making the substrate 11A of the electroconductive substrate 11 of the working electrode 10. The electroconductive layer 22 includes, for example, at least one electroconductive material and, if necessary, a binder. Examples of the electroconductive material for use in the electroconductive layer 22 include metals, such as platinum, gold, silver, copper (Cu), rhodium (Rh), ruthenium (Ru), aluminum (Al), magnesium (Mg), and indium (In); carbon (C); and electroconductive polymers. Examples of the binder for use in the electroconductive layer 22 include acrylic resins, polyester resins, phenol resins, epoxy resins, cellulose, melamine resins, fluoroelastomers, and polyimide resins. The counter electrode 20 may have a single layer structure formed of the electroconductive layer 22.

The electrolyte-containing layer 30 includes, for example, a redox electrolyte having an oxidation-reduction couple. Examples of the redox electrolyte include an I⁻/I₃⁻ couple, a Br⁻/Br₃⁻ couple, a quinone/hydroquinone couple, a cobalt complex, and a nitroxyl radical compound. Specifically, the redox electrolyte is exemplified by a halide/halogen couple, such as an iodide/iodine couple or a bromide/bromine couple. Examples of the halide include a cesium halide, a quaternary alkylammonium halide, an imidazolium halide, a thiazolium halide, an oxazolium halide, a quinolinium halide, and a pyridinium halide. Specifically, examples of the iodide include lithium iodide, sodium iodide, potassium iodide, cesium iodide; quaternary alkylammonium iodides, such as tetraethylammonium iodide, tetrapropylammonium iodide, tetrabutylammonium iodide, tetrapentylammonium iodide, tetrahexylammonium iodide, tetraheptylammonium iodide, and trimethylphenylammonium iodide; imidazolium iodides, such as 3-methylimidazolium iodide and 1-propyl-2,3-dimethylimidazolium iodide; thiazolium iodides, such as 3-ethyl-2-methyl-2-thiazolium iodide, 3-ethyl-5-(2-hydroxyethyl)-4-methylthiazolium iodide, and 3-ethyl-2-methylbenzothiazolium iodide; oxazolium iodides, such as 3-ethyl-2-methylbenzoxazolium iodide; quinolinium iodides, such as 1-ethyl-2-methylquinolinium iodide; and pyridinium iodides. Examples of the bromides include quaternary alkylammonium bromides. Of the halide/halogen couples preferred are couples of at least one of the above listed iodides and iodine.

The redox electrolyte may be, for example, a combination of an ionic liquid and a halogen. In this case, the redox electrolyte may further contain the above described halide. Examples of the ionic liquid include those usable in electric batteries and solar cells, such as those disclosed in Inorg. Chem., 1996, 35, pp. 1168-1178, Electrochemistry, 2002, 2, pp. 130-136, JP 9-507334A, and JP 8-259543A. Preferred of them are salts whose melting temperature is below room temperature (25°C) or salts the melting temperature of which is higher than room temperature but which are liquefied at room temperature on dissolving with other fused salt. Specific examples of the ionic liquids are anions and cations described below.

Examples of cations of ionic liquids are ammonium, imidazolium, oxazolium, thiazolium, oxadiazolium, triazolium, pyrrolidinium, pyridinium, piperidinium, pyrazolium, pyrimidinium, pyradinium, triazinium, phosphonium, sulfonium, carbazolium, indolium, and derivatives thereof. They may be used either individually or as a mixture of two or more thereof. Specific examples include 1-methyl-3-propylimidaqzolium, 1-butyl-3-methylimidazolium, 1,2-dimethyl-3-propylimidazolium, and 1-ethyl-3-methylimidazolium.

Examples of anions of ionic liquids include metal chloride ions, e.g., AlCl₄⁻ and Al₂Cl₇⁻; fluorine-containing compound ions, such as PF₆⁻, BF₄⁻, CF₃SO₃⁻, N(CF₃SO₂)₂⁻, F(HF)ₙ⁻, and CF₃COO⁻; fluorine-free compound ions, such as NO₃⁻, CH₃COO⁻, C₆H₁₁COO⁻, CH₃OSO₃⁻, CH₃OSO₂⁻, CH₃SO₃⁻, CH₃SO₂⁻, (CH₃O)₂PO₂⁻, N(CN)₂⁻, and SCN⁻; and other halide ions, such as an iodide ion and a bromide ion. These anions may be used either individually or as a mixture of two or more thereof. Preferred of these anions of ionic liquids is an iodide ion.

The electrolyte-containing layer 30 may be a liquid electrolyte (electrolyte solution) prepared by dissolving the redox electrolyte in a solvent or a solid polymer electrolyte in which an electrolyte solution is held in a polymer matrix. The electrolyte-containing layer 30 may also be a pseudo-solid (pasty) electrolyte containing a mixture of an electrolyte solution and a particulate carbon material, such as carbon black. The pseudo-solid electrolyte containing a carbon material does not need to contain a halogen simple substance because the carbon material functions to catalyze an oxidation-reduction reaction. The redox electrolyte may contain one or more organic solvents capable of dissolving the described halide or ionic liquid. The solvents include electrochemically inert solvents, such as acetonitrile, tetrahydrofuran, propionitrile, butyronitrile, methoxyacetonitrile, 3-methoxypropionitrile, valeronitrile, dimethyl carbonate, ethylmethyl carbonate, ethylene carbonate, propylene carbonate, N-methylpyrrolidone, pentyl alcohol, quinoline, N,N-dimethylformamide, γ-butyrolactone, dimethyl sulfoxide, and 1,4-dioxane.

For the purpose of improving power generation efficiency, durability, and the like of the photoelectric device, the electrolyte-containing layer 30 may contain acyclic saccharides (see JP 2005-093313A), pyridine compounds (see JP 2003-331936A), urea derivatives (see JP 2003-168493A), sheet clay minerals (see US 2007-531206A), dibenzylidene D-sorbitol, cholesterol derivatives, amino acid derivatives, trans-(1R,2R)-1,2-cyclohexanediamine alkylamide derivatives, alkylurea derivatives, N-octyl-D-gluconamide benzoate, double-headed amino acid derivatives, quaternary ammonium derivatives, and so on.

When light (sunlight or ultraviolet, visible, or near infrared light equal to sunlight) enters the photoelectric device, the dye 13 loaded on the working electrode 10 absorbs the light, and the thus photoexcited dye 13 injects electrons into the metal oxide semiconductor layer 12. The electrons move to the adjacent electroconductive layer 11B, passes through an outer circuit, and reach the counter electrode 20. On the other hand, the electrolyte in the electrolyte-containing layer 30 is oxidized to return (reduce) the dye 13 having been oxidized with the movement of electrons to the ground state. The thus oxidized electrolyte is reduced upon receipt of the electrons having reached the counter electrode 20. In this way, the electron movement between the working electrode 10 and the counter electrode 20 and the associated oxidation-reduction reaction in the electrolyte-containing layer 30 are repeated, whereby electrons move continuously to steadily perform photoelectric conversion.

The photoelectric device of the invention is fabricated, for example, as follows.

A working electrode is provided. First of all, a metal oxide semiconductor layer 12 having a porous structure is formed on the side of the electroconductive layer 11B of the electroconductive substrate 11 by electrodeposition or a firing method. The electrodeposition is carried out by, for example, heating an electrolytic bath containing a metal salt providing a metal oxide semiconductor material to a predetermined temperature while bubbling with oxygen or air, immersing the electroconductive substrate 11 therein, and applying a given voltage between the substrate 11 and a counter electrode, thereby to deposit a metal oxide semiconductor material with a porous structure on the electroconductive layer 11B. The counter electrode may be moved appropriately in the electrolytic bath. The firing method is carried out by, for example, dispersing powder of a metal oxide semiconductor material in a medium, applying the resulting metal oxide slurry to the electroconductive substrate 11, followed by drying, followed by firing to form a porous structure. Then a dye solution containing an organic solvent, an amine, and a dye 13 is prepared. The electroconductive substrate 11 having the metal oxide semiconductor layer 12 is immersed in the dye solution to fix the dye 13 onto the metal oxide semiconductor layer 12. In the step of preparing the dye solution, the amine is added to the organic solvent after dissolving the dye 13 in the organic solvent. Then, the electroconductive substrate 11 is immersed in the dye solution to load the dye 13 on the metal oxide semiconductor layer 12.

The concentration of the dye compound (sensitizing dye) in the dye solution is preferably 1.0 × 10⁻⁵ to 1.0 × 10⁻³ mol/dm³, more preferably 5.0 × 10⁻⁵ to 5.0 × 10⁻⁴ mol/dm³.

A counter electrode 20 is made by providing an electroconductive layer 22 on one side of an electroconductive substrate 21. The electroconductive layer 22 can be formed by, for example, sputtering an electroconductive material.

The working electrode 10 and the counter electrode 20 are put together with a predetermined space therebetween using an unshown spacer, such as a sealant, such that the side of the dye 13 of the working electrode 10 and the side of the electroconductive layer 22 of the counter electrode 20 face each other, and the assembly is totally sealed while leaving an inlet for injecting an electrolyte. Subsequently, an electrolyte is injected through the inlet into the space between the working electrode 10 and the counter electrode 20, followed by sealing the inlet to form the electrolyte-containing layer 30. There is thus completed a photoelectric device illustrated in Figs. 1 and 2.

While the photoelectric device has been described with particular reference to the configuration in which the electrolyte-containing layer 30 is provided between the working electrode 10 and the counter electrode 20, the electrolyte-containing layer 30 may be replaced with a solid charge transfer layer. In that case, the solid charge transfer layer has a solid material in which carrier transfer takes part in electric conduction. Such a material is preferably an electron transport material or a hole transport material.

Examples of the hole transport material include aromatic amines and triphenylene derivatives, such as oligothiophene compounds, polypyrrole, polyacetylene or its derivatives, poly(p-phenylene) or its derivatives, poly(p-phenylenevinylene) or its derivatives, polythienylenevinylene or its derivatives, polythiophene or its derivatives, polyaniline or its derivatives, polytoluidine or its derivatives, and like organic electroconductive polymers.

A p-type inorganic compound semiconductor may be used as the hole transport material. The p-type inorganic compound semiconductor preferably has a band gap of 2 eV or more, more preferably 2.5 eV or more. The ionization potential of the p-type inorganic compound semiconductor must be smaller than that of the working electrode 10 in order to secure the condition for reducing the positive holes of the dye. The ionization potential of the p-type inorganic compound semiconductor, while varying depending on the dye used, is preferably 4.5 to 5.5 eV, more preferably 4.7 to 5.3 eV.

Examples of the p-type inorganic compound semiconductor include compound semiconductors containing monovalent copper. Examples of compound semiconductors containing monovalent copper include CuI, CuSCN, CuInSe₂, Cu(In,Ga)Se₂, CuGaSe₂, Cu₂O, CuS, CuGaS₂, CuInS₂, and CuAlSe₂. Another examples of the p-type inorganic compound semiconductor include GaP, NiO, CoO, FeO, Bi₂O₃, MoO₂, and Cr₂O₃.

The solid charge transfer layer may be formed directly on the working electrode 10, and then a counter electrode may be formed thereon.

The hole transport material including the organic photoconductive polymer may be introduced into the inside of the electrode by, for example, vacuum deposition, casting, coating, spin coating, dipping, electrolytic polymerization, or photo electro lytic polymerization. The hole transport material including the inorganic solid compound may be introduced into the inside of the electrode by, for example, casting, coating, spin coating, dipping, or electroplating. It is preferred that part of the thus formed solid charge transport layer, particularly a layer containing a hole transport material, partially penetrate the voids of the porous structure of the metal oxide semiconductor layer 12 to come into direct contact with the metal oxide semiconductor material.

The applications of the photoelectric device of the invention are not limited to the aforementioned solar cell and include, for example, photosensors.

### Examples

The invention will now be illustrated in greater detail with reference to Examples and Comparative Examples of the loading method, support system, and photoelectric device of the invention. It should be noted that the invention is not limited thereto.

### Preparation of titanium oxide support (electroconductive substrate 11)

An electroconductive glass substrate 11 made of F-SnO₂ measuring 2.0 cm in length, 1.5 cm in width, and 1.1 mm in thickness was provided. A 70 µm thick masking tape was stuck on the substrate 11 to surround a 0.5 cm-side square. A metal oxide slurry prepared by suspending titanium oxide (TiO₂) powder (Ti-Nanoxide D from Solaronix) in water in a concentration of 10 wt% was applied to the square to a uniform thickness and dried. After the masking tape was removed, the substrate 11 was fired in an electric oven at 450°C to form a metal oxide semiconductor layer 12 with a thickness of about 5 µm.

### Making of support system (working electrode 10)

A dye (compound to be loaded) and an amine were dissolved in an organic solvent in a concentration of 0.3 mM and 3.0 mM, respectively, to prepare a dye solution according to the composition shown in Table 1 below. The dye solution was ultrasonicated for 30 minutes, followed by filtration using a membrane filter (DISMIC-HP045AN). The titanium oxide support prepared above was immersed in the filtered dye solution until saturated to make a working electrode 10. The temperature of the dye solution was 25°C.

### Evaluation of loading ratio

The time required until the amount of the dye loaded on the support reached saturation was taken as a measure of loading ratio. The loading ratio was expressed relatively taking the loading ratio obtained when no amine was used as 1. The greater the relative value, the more the effect of the amine in increasing the amount of the dye loaded. The results obtained are shown in Table 1.

**Table 1**

| Support system | Dye | Amine | Organic Solvent | Adsorption Rate |
|---|---|---|---|---|
| No. 1 | dye 1 | triethylamine | ethanol | 2.08 |
| No. 2 | dye 1 | tripropylamine | ethanol | 1.60 |
| No. 3 | dye 1 | tributylamine | ethanol | 2.22 |
| No. 4 | dye 1 | trihexvlamine | ethanol | 2.54 |
| No. 5 | dye 1 | dibutylamine | ethanol | 2.26 |
| No. 6 | dye 1 | butylamine | ethanol | 2.06 |
| No. 7 | dye 1 | dimethylammoethanol | ethanol | 1.40 |
| No. 8 | dye 1 | dimethylpiperazine | ethanol | 1.95 |
| No. 9 | dye 1 | imidazole | ethanol | 1.32 |
| No. 10 | dye 1 | pyridine | ethanol | 1.21 |
| No. 11 | dye 1 | diethylaniline | ethanol | 1.92 |
| No. 12 | dye 1 | diisopropylethylamine | ethanol | 1.95 |
| No. 13 | dye 1 | trioctylamine | ethanol | 3.17 |
| No. 14 | dye 1 | butyldiethanolamine | ethanol | 3.63 |
| No. 15 | dye 1 | - | ethanol | 1.00 |
| No. 16 | dye 2 | triethylamine | ethanol | 2.59 |
| No. 17 | dye 2 | trioctylamine | ethanol | 2.69 |
| No. 18 | dye 2 | - | ethanol | 1.00 |
| No. 19 | dye 3 | dibutylamine | ethanol | 1.25 |
| No. 20 | dye 3 | butylamine | ethanol | 1.16 |
| No. 21 | dye 3 | - | ethanol | 1.00 |
| No. 22 | dye 4 | dibutylamine | ethanol | 2.56 |
| No. 23 | dye 4 | trioctylamine | ethanol | 2.55 |
| No. 24 | dye 4 | - | ethanol | 1.00 |
| No. 25 | dye 5 | dibutylamine | ethanol | 1.07 |
| No. 26 | dye 5 | trioctylamine | ethanol | 1.08 |
| No. 27 | dye 5 | - | ethanol | 1.00 |
| No. 28 | dye 6 | dibutylamine | ethanol | 1.04 |
| No. 29 | dye 6 | trioctylamine | ethanol | 1.02 |
| No. 30 | dye 6 | - | ethanol | 1.00 |
| No. 31 | dye 7 | dibutylamine | ethanol | 1.01 |
| No. 32 | dye 7 | trioctylamine | ethanol | 1.02 |
| No. 33 | dye 7 | - | ethanol | 1.00 |
| No. 34 | dye 8 | dibutylamine | ethanol | 1.23 |
| No. 35 | dye 8 | trioctylamine | ethanol | 1.28 |
| No. 36 | dye 8 | - | ethanol | 1.00 |
| No. 37 | dye 9 | dibutylamine | ethanol | 1.15 |
| No. 38 | dye 9 | trioctylamine | ethanol | 1.20 |
| No. 39 | dye 9 | - | ethanol | 1.00 |
| No. 40 | dye 10 | dibutylamine | ethanol | 1.10 |
| No. 41 | dye 10 | trioctylamine | ethanol | 1.04 |
| No. 42 | dye 10 | - | ethanol | 1.00 |
| No. 43 | dye 1 | dibutylamine | 2-propanol | 2.45 |
| No. 44 | dye 1 | trioctylamine | 2-propanol | 3.33 |
| No. 45 | dye 1 | - | 2-propanol | 1.00 |

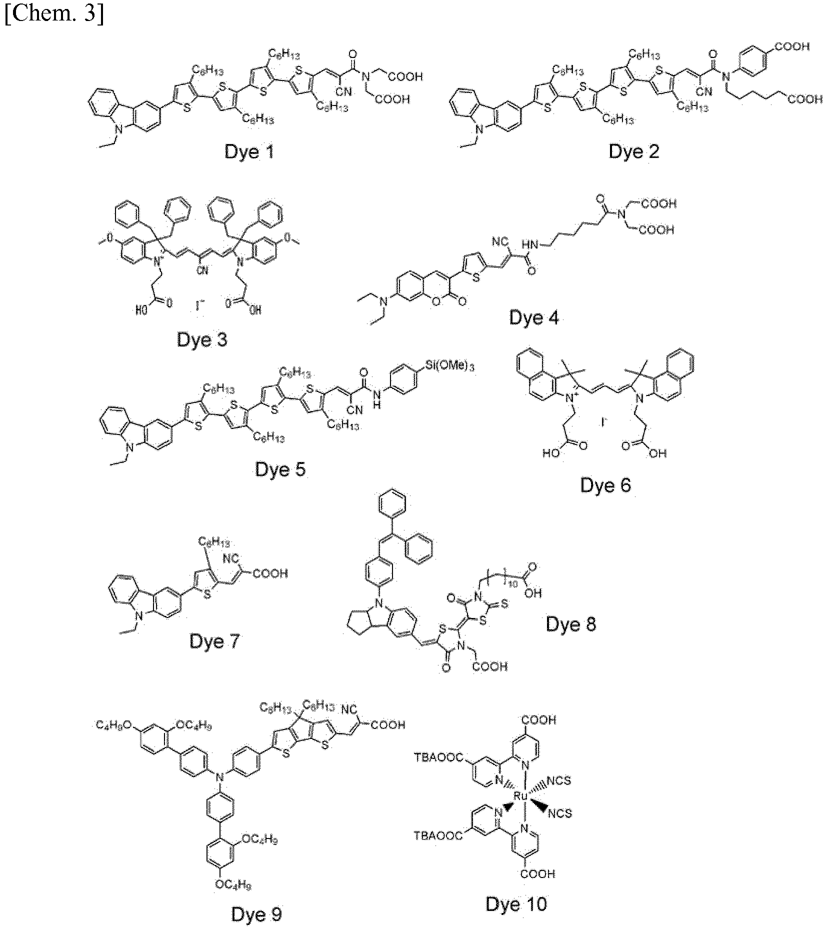

### Evaluation of photoelectric efficiency

A photoelectric device illustrated in Fig. 1 was fabricated as follows. The prepared working electrode 10 and a counter electrode 20 were assembled together with a 63 µm thick spacer therebetween to provide a space for an electrolyte-containing layer 30 therebetween and fixed by clips. The counter electrode 20 was prepared by coating an ITO electrode (from Nishinoda Denko Co., Ltd.) as an electroconductive substrate 21 with graphite particles (electroconductive layer 22). An electrolyte solution prepared by dissolving iodine (0.05 mM) and lithium iodide (0.5 mM) in acetonitrile was penetrated into the space to form an electrolyte-containing layer 30, thereby to fabricate a photoelectric device. The upper side of the device was covered with a mask having an opening of 1 cm². The conversion efficiency η (%) of the device was determined using a solar simulator under the conditions of AM 1.5G and 100 mW/cm². The conversion efficiency relative to that of the devices prepared using no amine (taken as 1) is shown in Table 2. The greater the relative value (the higher the photoelectric efficiency), the higher the effect of the amine added in the dye fixing step.

**Table 2**

| Support system | Dye | Amine | Organic Solvent | Photoelectric Efficiency |
|---|---|---|---|---|
| No. 1 | dye 1 | triethylamine | ethanol | 1.21 |
| No. 3 | dye 1 | tributylamine | ethanol | 1.36 |
| No. 4 | dye 1 | dibutylamine | ethanol | 1.38 |
| No. 7 | dye 1 | dimethylpiperazine | ethanol | 1.15 |
| No. 8 | dye 1 | imidazole | ethanol | 1.16 |
| No. 11 | dye 1 | diisopropylethylamine | ethanol | 1.12 |
| No. 12 | dye 1 | trioctylamine | ethanol | 1.23 |
| No. 13 | dye 1 | butyldiethanolamine | ethanol | 1.31 |
| No. 14 | dye 1 | - | ethanol | 1.00 |
| No. 21 | dye 4 | dibutylamine | ethanol | 2.41 |
| No. 22 | dye 4 | trioctylamine | ethanol | 2.35 |
| No. 23 | dye 4 | - | ethanol | 1.00 |
| No. 27 | dye 6 | dibutylamine | ethanol | 1.07 |
| No. 28 | dye 6 | trioctylamine | ethanol | 1.10 |
| No. 29 | dye 6 | - | ethanol | 1.00 |
| No. 33 | dye 8 | dibutylamine | ethanol | 1.07 |
| No. 34 | dye 8 | trioctylamine | ethanol | 1.11 |
| No. 35 | dye 8 | - | ethanol | 1.00 |
| No. 36 | dye 9 | dibutylamine | ethanol | 1.03 |
| No. 37 | dye 9 | trioctylamine | ethanol | 1.08 |
| No. 38 | dye 9 | - | ethanol | 1.00 |
| No. 39 | dye 10 | dibutylamine | ethanol | 1.23 |
| No. 40 | dye 10 | trioctylamine | ethanol | 1.19 |
| No. 41 | dye 10 | - | ethanol | 1.00 |
| No. 42 | dye 1 | dibutylamine | 2-propanol | 1.32 |
| No. 43 | dye 1 | trioctylamine | 2-propanol | 1.22 |
| No. 44 | dye 1 | - | 2-propanol | 1.00 |

It is apparent from the above results that the method of the invention achieves improved loading ratio and that the support system prepared by the method provides high photoelectric efficiency when used as an electrode of a photoelectric device.

## Claims

1. A method for loading a compound on a support in an organic solvent, wherein the organic solvent contains an amine.

2. The method according to claim 1, wherein the organic solvent has a hydroxy group.

3. The method according to claim 1 or 2, wherein the compound has at least one group selected from a carboxyl group, a sulfonic group, a phosphate group, a phosphonic group, and an alkoxysilyl group.

4. The method according to any one of claims 1 to 3, wherein the support is a metal oxide.

5. A compound-loaded support system obtained by the method according to any one of claims 1 to 4.

6. A photoelectric device comprising an electrode containing the compound-loaded support system according to claim 5.
